# EUROPÄISCHE PATENTANMELDUNG

(11) **EP 2 876 414 A1**
(43) Veröffentlichungstag der Anmeldung: **27.05.2015**
(21) Anmeldenummer: 14191303.8
(22) Anmeldetag: 31.10.2014
(51) Int. Cl.: G01D 5/20, H01F 3/08

(54) **Induktiver Sensor und Verfahren zum Herstellen eines induktiven Sensors**

(30) Priorität: 01.11.2013 DE 102013222276
(71) Anmelder: Rolls-Royce Deutschland Ltd & Co KG, 15827 Blankenfelde-Mahlow (DE)
(72) Erfinder: Rosenau, Knut, 15378 Herzfelde (DE)
(74) Vertreter: Gross, Felix

(57) **Zusammenfassung**

Die Erfindung betrifft einen induktiven Sensor (10) und ein Verfahren zum Herstellen eines induktiven Sensors (10). Der induktive Sensor (10) umfasst einen Wicklungskörper (11), eine Induktionsspule (15) aus einer hochtemperaturfähigen Metalllegierung, die auf den Wicklungskörper (11) gewickelt ist, und ein die Induktionsspule (11) zumindest teilweise umgebendes Metallgehäuse (16). Dabei ist die Induktionsspule (15) mit Metalloxid-Pulver (20) im Metallgehäuse (16) verpresst.

## Beschreibung

Die Erfindung betrifft einen induktiven Sensor sowie ein Verfahren zum Herstellen eines induktiven Sensors. Ein beispielhaftes Anwendungsfeld der Erfindung liegt in der Bereitstellung eines Drehzahlsensors für eine Gasturbine.

Induktive Sensoren sind allgemein bekannt. Sie umfassen eine auf einen Wicklungskörper gewickelte Spule, die beispielsweise Teil eines Schwingkreises ist, dessen Amplitude und/oder Frequenz sich im elektromagnetischen Feld eines vorbeigeführten Körpers ändern. Es erfolgt eine verschleißfreie und berührungslose Messung.

Es besteht allgemein ein Bedarf, induktive Sensoren bereitzustellen, die hochtemperaturfähig sind und dementsprechend in Hochtemperaturumgebungen einsetzbar sind, beispielsweise im Turbinenbereich einer Gasturbine. Dabei ist es erstrebenswert, hochtemperaturfähige induktive Sensoren bereitzustellen, die ohne eine gesonderte Kühlung auskommen.

Dementsprechend liegt der vorliegenden Erfindung die Aufgabe zugrunde, einen induktiven Sensor bereitzustellen, der auch ohne Bereitstellung einer Kühlung hochtemperaturfähig ist. Des Weiteren soll ein Verfahren zur Herstellung eines solchen hochtemperaturfähigen induktiven Sensors bereitgestellt werden.

Diese Aufgabe wird erfindungsgemäß durch einen induktiven Sensor mit den Merkmalen des Anspruchs 1 und ein Verfahren zum Herstellen eines induktiven Sensors mit den Merkmalen des Anspruchs 10 gelöst. Ausgestaltungen der Erfindung sind in den Unteransprüchen angegeben.

Die erfindungsgemäße Lösung sieht somit eine auf einen Wicklungskörper gewickelte Induktionsspule vor, die aus einer hochtemperaturfähigen Metalllegierung, z.B. einer Nickelbasislegierung oder nicht rostendem Stahl besteht. Die Induktionsspule ist zumindest teilweise von einem Metallgehäuse umgeben. In dem Metallgehäuse ist die Induktionsspule mit Metalloxid-Pulver verpresst.

Durch das Verpressen der Induktionsspule im Metallgehäuse mit Metalloxid-Pulver erfolgt eine elektrische Isolation der Induktionsspule. Insbesondere werden durch das Metalloxid-Pulver die einzelnen Windungen der Wicklung der Induktionsspule zueinander isoliert und wird dadurch die Gefahr eines Kurzschlusses vermieden. Dabei ist zu beachten, dass die Induktionsspule aufgrund der gewünschten Hochtemperaturfähigkeit nicht mit einem Isolationslack oder dergleichen versehen ist. Es wird ein hochtemperaturfähiger induktiver Sensor bereitgestellt, der beispielsweise zur Drehzahlmessung an Rotoren in Heißgasbereichen eingesetzt werden kann. Eine Kühlung des Sensors ist aufgrund der verwendeten hitzebeständigen Materialien und der elektrischen Isolation mit Metalloxid-Pulver nicht erforderlich.

Das erfindungsgemäße Merkmal, dass die Induktionsspule mit Metalloxid-Pulver im Metallgehäuse verpresst ist, bedeutet, dass das Metalloxid-Pulver mit einem Druck im Metallgehäuse vorliegt, der gegenüber dem Umgebungsdruck erhöht ist. Dies wird dadurch erreicht, dass das Metallgehäuse nach Einbringen des Metalloxid-Pulvers in das Metallgehäuse verformt wird, wie noch im Hinblick auf das erfindungsgemäße Verfahren im Einzelnen erläutert werden wird. Das Verformen des Metallgehäuses geht einher mit einer Verdichtung des Metallpulvers im Metallgehäuse, wobei das Metallpulver nach dem Verpressen weiterhin als Metallpulver vorliegt und nicht versintert ist. So sind die Temperaturen beim Verpressen und auch im Betrieb des Sensors, die typischerweise im Bereich zwischen 400°C und 800°C, insbesondere im Bereich zwischen 600°C und 800°C liegen, zu gering, um zu einem Versintern des Metallpulvers zu führen.

Dabei kann vorgesehen sein, dass ein mit dem Verformen des Metallgehäuses ebenfalls grundsätzlich einhergehender erhöhter Luftdruck im Metallgehäuse durch Öffnungen im Metallgehäuse entlastet wird. Auch kann zur Vermeidung eines solchen erhöhten Luftdruckes vorgesehen sein, dass das Verformen des Metallgehäuses und damit das Verpressen der Induktionsspule im Metallgehäuse mit Metalloxid-Pulver unter Vakuum erfolgt.

Die Induktionsspule (d.h. der Spulendraht bzw. die Induktionswicklung, die die Induktionsspule bildet) besteht wie ausgeführt aus einer Nickelbasislegierung, aus einem nichtrostenden Stahl oder aus einer anderen hochtemperaturfähigen Metalllegierung. Als nichtrostender Stahl (rostfreier Stahl) wird in Übereinstimmung mit der hierzu üblichen Definition ein Stahl mit einem Anteil von mehr als 10,5 % Chrom, der im austenitischen oder ferrritischen Mischkristall gelöst ist, bezeichnet. Dass die Induktionsspule aus einer hochtemperaturfähigen Metalllegierung besteht, bedeutet beispielsweise, dass die Metalllegierung bis zu einer Temperatur von mindestens 400°C, mindestens 600 °C oder mindestens 800 °C temperaturbeständig ist. Dabei liegt auch bei hohen Temperaturen eine gute elektrische Leitfähigkeit vor.

In einer Ausgestaltung der Erfindung ist der Wicklungskörper als Dauermagnet ausgebildet, d. h. er besteht aus einem dauermagnetischen Material. Dieses ist in einer Ausgestaltung mit einer keramischen Beschichtung versehen, um eine Isolation zu den Wicklungen der Induktionsspule bereitzustellen. Das dauermagnetische Material ist ebenfalls hochtemperaturfähig und kann beispielsweise kobalt- oder eisen-basiert sein.

In einer alternativen Ausgestaltung ist der Wicklungskörper als keramischer Wicklungskörper ausgebildet. Dabei kann vorgesehen sein, dass in den keramischen Körper ein Dauermagnet eingelegt ist, um die Induktivität des Sensors zu erhöhen. Ein solcher Dauermagnet ist ebenfalls hochtemperaturfähig und kann beispielsweise kobalt- oder eisen-basiert sein.

Das Metallgehäuse ist gemäß einer Ausgestaltung der Erfindung bis zu einer Temperatur von mindestens 600 °C, insbesondere bis zu einer Temperatur von mindestens 800 °C temperaturbeständig ausgebildet, so dass es auch bei diesen hohen Temperaturen seine Umhüllungs- und Schutzfunktion ausüben kann. Je nach benötigter Hochtemperaturfähigkeit des induktiven Sensors kann auch eine andere Temperaturbeständigkeit des Metallgehäuses vorgesehen sein.

Das Metallgehäuse besteht beispielsweise aus einer Nickelbasislegierung, aus nichtrostendem Stahl, aus einer Titanlegierung oder aus einer anderen hochtemperaturfähigen Metalllegierung.

Gemäß einer weiteren Ausgestaltung der Erfindung ist das Metallgehäuse rohrförmig ausgebildet. Dabei kann vorgesehen sein, dass der Wicklungskörper einen Bodenbereich und einen Deckelbereich integriert ausbildet, an denen das Metallgehäuse befestigt ist. Hierzu kann beispielsweise vorgesehen sein, dass der Bodenbereich und der Deckelbereich jeweils eine Fase ausbilden, die von einem gebördelten Rand des Metallrohres überdeckt wird, um das Metallrohr formschlüssig am Boden- und Deckelbereich des Wicklungskörpers zu befestigen.

In anderen Ausgestaltungen der Erfindung ist das Metallgehäuse geschlossen ausgebildet, d. h. es bildet beispielsweise einen geschlossenen Zylinder oder einen geschlossenen Quader oder eine andere geometrische Grundform, wobei jedoch Öffnungen zum Durchführen von Kabeln und elektrischen Anschlüssen vorhanden sind. In diesem Fall werden Boden und Deckel des Gehäuses nicht durch den Wicklungskörper selbst gebildet, sondern durch das Metallgehäuse, wobei der Wicklungskörper vollständig in dem Metallgehäuse angeordnet ist. Deckel und Boden können aus dem Metallgehäuse ausgeformt sein oder als separate Bauteile in das Metallgehäuse eingeschweißt oder eingelötet sein.

Bei sämtlichen Ausgestaltungen ist die Induktionsspule mit Metalloxid-Pulver im Metallgehäuse verpresst. Hierzu werden beispielsweise radial von außen Presskräfte auf das Sensorgehäuse aufgebracht. Dies wird im Hinblick auf das erfindungsgemäße Verfahren noch näher erläutert werden.

Es kann vorgesehen sein, dass in der Außenseite des Metallgehäuses mindestens eine Nut ausgebildet ist, in der ein Dichtmittel, beispielsweise eine hochtemperaturfähige Dichtschnur, angeordnet ist. Hierdurch wird eine Abdichtung des Sensors nach außen gegenüber angrenzenden Bauteilen bereitgestellt, insbesondere gegen Luftleckage bei anliegenden Druckdifferenzen.

Eine weitere Ausgestaltung der Erfindung sieht vor, dass der Wicklungskörper ein Außengewinde ausbildet, das dazu vorgesehen und ausgebildet ist, die aufzuwickelnde Induktionsspule aufzunehmen.

Bei dem Metalloxid-Pulver, mit dem die Induktionsspule im Metallgehäuse verpresst ist, handelt es sich beispielsweise um ein Magnesiumoxid-Pulver. Jedoch können auch andere Metalloxid-Pulver Einsatz finden, wie z.B. Zirkonoxid oder Titanoxid.

Die Erfindung betrifft des Weiteren ein Verfahren zum Herstellen eines induktiven Sensors. Das Verfahren weist die folgenden Schritte auf:
- Wickeln einer Induktionsspule aus einer hochtemperaturfähigen Metalllegierung auf einen Wicklungskörper,
- Anordnen der auf den Wicklungskörper gewickelten Induktionsspule in einem Metallgehäuse zusammen mit einem Metalloxid-Pulver,
- Verschließen des Metallgehäuses derart, dass im Wesentlichen kein Metalloxid-Pulver nach außen treten kann, und
- anschließend Verformen des Metallgehäuses, wobei die Induktionsspule mit dem Metalloxid-Pulver verpresst wird und das Metallgehäuse seine endgültige äußere Form erhält. Dabei liegt das Metallpulver nach dem Verpressen weiterhin als Metallpulver vor und ist nicht versintert.

Somit wird das Metallgehäuse bei dem erfindungsgemäßen Verfahren nach Einbringen der auf den Wicklungskörper gewickelten Induktionsspule und deren Einbetten in Metalloxid-Pulver verformt. Durch dieses Verformen wird die Induktionsspule mit dem Metalloxid-Pulver verpresst. Die im Metalloxidpulver enthaltene Luft kann gegebenenfalls durch entsprechende Öffnungen im Metallgehäuse, Boden und/oder Deckel oder die Durchführungsöffnungen der Sensorwicklungen entweichen.

Das Verschließen des Metallgehäuses derart, dass im Wesentlichen kein Metalloxid-Pulver nach außen treten kann, bedeutet, dass der Anteil an Metalloxid-Pulver, der ggf. nach außen tritt, unter 10% der Gesamtmasse des Metalloxid-Pulvers liegt. Das Verschließen des Metallgehäuses kann vorläufig oder endgültig erfolgen. Sofern das Verschließen nur vorläufig erfolgt, erfolgt ein endgültiges Verschließen nach Beendigung des Verformvorgangs.

Das Verformen des Metallgehäuses erfolgt in einer Ausgestaltung der Erfindung dadurch, dass auf das Metallgehäuse radial von außen Presskräfte aufgebracht werden, so dass das Metallgehäuse in radialer Richtung gepresst wird. Je nach Form des Metallgehäuses kann dies dazu führen, dass das Sensorgehäuse nach dem Pressvorgang einer verpressten Presshülse ähnelt. Das Pressen in radialer Richtung von außen erfolgt in einer Ausgestaltung mehrfach unter versetzten Umfangswinkeln, um eine erhöhte Rundheit des gepressten Metallgehäuses zu erreichen.

Das Aufbringen von Presskräften in radialer Richtung auf das Metallgehäuse erfolgt derart, dass ein Deckelbereich des Metallgehäuses, durch den Kabel oder andere elektrische Anschlüsse verlaufen, beim Pressen nicht verformt wird, so dass die elektrischen Anschlüsse nicht beschädigt werden. Hierzu kann vorgesehen sein, dass das Metallgehäuse ausschließlich in radialer Richtung in einem axialen Bereich des Metallgehäuses, der zwischen dem Deckelbereich und dem Bodenbereich des Metallgehäuses liegt, verformt wird.

Grundsätzlich sind jedoch auch Ausgestaltungen denkbar, bei denen der Pressvorgang eine axiale Komponente aufweist oder in axialer Richtung erfolgt. Beispielsweise ist es denkbar, dass der Bodenbereich des Metallgehäuses, sofern durch diesen keine Kabel oder anderen elektrischen Anschlüsse verlaufen, zumindest teilweise in axialer Richtung gepresst wird. Bei Aufbringen von Presskräften in axialer Richtung sind diese allerdings derart anzulegen, dass die Bereiche des Sensors, die der Durchführung von elektrischen Kabeln und anderen elektrischen Anschlüssen dienen, nicht beschädigt werden. Es ist dabei darauf zu achten, daß die Wicklungen nicht axial verrutschen und durch gegenseitige Berührung Kurzschluss verursacht wird.

Gemäß einer Ausgestaltung des erfindungsgemäßen Verfahrens weist das Metallgehäuse vor dem Verformen des Metallgehäuses eine bauchige Wölbung nach außen auf. Das Metallgehäuse wird dadurch verformt, dass auf die Wölbung von außen ein Druck ausgeübt und diese dadurch zumindest teilweise beseitigt wird. Beispielsweise kann vorgesehen sein, dass das Metallgehäuse als Metallrohr ausgebildet ist, wobei das Metallrohr vor dem Verformen eine Ausdellung besitzt, die durch das Verformen (z. B. durch Aufbringen von Presskräften in radiale Richtung von außen) im Wesentlichen beseitigt wird.

Jedoch kann ein Verformen des Metallgehäuses auch in anderer Weise als durch Aufbringen einer Presskraft auf eine Wölbung des Metallgehäuses erfolgen. Beispielsweise kann alternativ vorgesehen sein, dass das Metallgehäuse ähnlich dem Balg einer Ziehharmonika eine Faltung aufweist, wobei durch Aufbringen einer Presskraft eine Verformung dadurch erfolgt, dass die Falten der Ziehharmonika-Faltung ihren Abstand zueinander verringern, wodurch das Metalloxid-Pulver im Metallgehäuse verpresst wird.

Jegliche Verform- und Pressvorgänge können durch das Einbringen hochfrequenter Schwingungen, die durch Teile der Pressvorrichtung über Metallgehäuse, Deckel und/oder Boden in das zu verdichtende Metalloxidpulver übertragen werden, unterstützt werden. Die hochfrequenten Schwingungen können insbesondere im Frequenzbereich von 20 kHz bis 100 kHz eingebracht werden, um eine gleichmäßigere Verdichtung des Metalloxidpulvers zu unterstützen und damit eine gleichmäßigere elektrische Isolationswirkung des Metalloxidpulvers zu erreichen.

Insbesondere erlaubt das Einbringen hochfrequenten Schwingungen während des Pressvorganges eine gleichmäßigere Verdichtung des Metalloxid-Pulvers beim Einbringen axialer Presswege.

Die Erfindung wird nachfolgend unter Bezugnahme auf die Figuren der Zeichnung anhand mehrerer Ausführungsbeispiele näher erläutert. Es zeigen:
- Fig. 1: ein Anwendungsbeispiel der Erfindung, bei dem ein induktiver Sensor als Drehzahlsensor im Heißbereich einer Gasturbine eingesetzt wird;
- Fig. 2: eine vergrößerte Axial-Teilschnitt-Ansicht eines Ausführungsbeispiels eines erfindungsgemäßen induktiven Sensors, wobei der induktive Sensor in einer schematisch dargestellte Pressvorrichtung angeordnet ist;
- Fig. 3A: ein erstes alternatives Ausführungsbeispiel des Wicklungskörpers des induktiven Sensors der Figur 2;
- Fig. 3B: ein zweites alternatives Ausführungsbeispiel des Wicklungskörpers des induktiven Sensors der Figur 2;
- Fig. 3C: ein drittes alternatives Ausführungsbeispiel des Wicklungskörpers des induktiven Sensors der Figur 2;
- Fig. 4A: ein drittes alternatives Ausführungsbeispiel eines Wicklungskörpers eines induktiven Sensors, wobei der Wicklungskörper einen Bodenbereich und einen Deckelbereich des Sensors integriert und mit einer keramischen Beschichtung versehen ist;
- Fig. 4B: ein viertes alternatives Ausführungsbeispiel eines Wicklungskörpers eines induktiven Sensors, wobei der Wicklungskörper einen Bodenbereich und einen Deckelbereich integriert;
- Fig. 4C: ein fünftes alternatives Ausführungsbeispiel eines Wicklungskörpers eines induktiven Sensors, wobei der Wicklungskörper einen Bodenbereich und einen Deckelbereich integriert;
- Fig. 5A: ein sechstes alternatives Ausführungsbeispiel eines Wicklungskörpers eines induktiven Sensors, wobei der Wicklungskörper einen Bodenbereich integriert;
- Fig. 5B: ein siebtes alternatives Ausführungsbeispiel eines Wicklungskörpers eines induktiven Sensors, wobei der Wicklungskörper einen Bodenbereich integriert;
- Fig. 5C: ein achtes alternatives Ausführungsbeispiel eines Wicklungskörpers eines induktiven Sensors, wobei der Wicklungskörper einen Bodenbereich integriert;
- Fig. 6A: die Anordnung einer auf einen Wicklungskörper gewickelten Induktionsspule in einem rohrförmigen Metallgehäuse, das eine Ausdellung ausbildet, vor einem Verformen des Metallgehäuses;
- Fig. 6B: den induktiven Sensor der Figur 6A nach Verformen des Metallgehäuses, wobei die Ausdellung des Metallgehäuses beseitigt worden ist;
- Fig. 6C: ein alternatives Ausführungsbeispiel des induktiven Sensors der Figur 6B, bei dem an der Außenseite des Metallgehäuses Nuten mit jeweils einer darin angeordneten Dichtschnur ausgebildet sind;
- Fig. 7A: eine weitere Ausgestaltung eines in einem Metallrohr mit einer Ausdellung angeordneten Wicklungskörper vor einem Verformen des Metallrohres, wobei der Wicklungskörper einen integrierten Deckel und einen integrierten Boden ausbildet;
- Fig. 7B: den induktiven Sensor der Figur 7A nach Verformen des Metallgehäuses, wobei die Ausdellung des Metallgehäuses beseitigt worden ist; und
- Fig. 7C: ein alternatives Ausführungsbeispiel des induktiven Sensors der Figur 7B, bei dem an der Außenseite des Metallgehäuses Nuten mit jeweils einer darin angeordneten Dichtschnur ausgebildet sind.

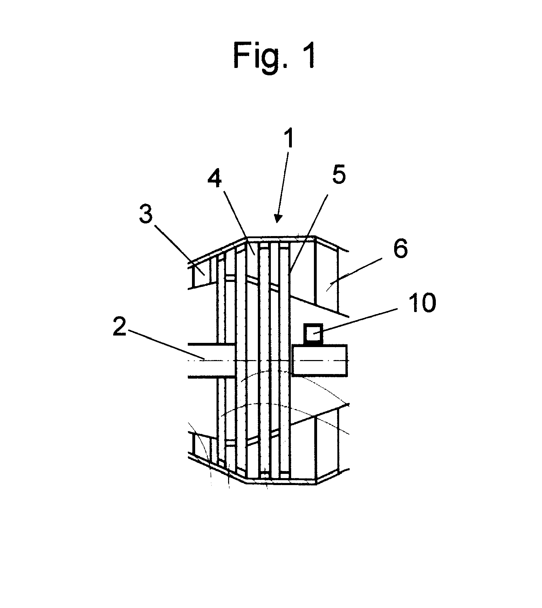

Die Figur 1 zeigt eine beispielhafte Anwendung für den Einsatz eines erfindungsgemäßen hochtemperaturfähigen induktiven Sensors 10. Der induktive Sensor 10 ist im Bereich einer Gasturbine 1 angeordnet, die in an sich bekannter Weise ausgebildet ist und in Strömungsrichtung hintereinander einen Lufteinlass 3, eine Turbine 4 mit mindestens einem Turbinenrotor 5 sowie eine Abgasdüse 6 umfasst, die sämtlich um eine zentrale Triebwerksachse 2 angeordnet sind.

Der induktive Sensor 10 ist im Ausführungsbeispiel der Figur 1 nahe der zentralen Triebwerksachse 2 angeordnet. Grundsätzlich kann er auch in anderen Bereichen der Gasturbine 1 angeordnet sein. Der induktive Sensor 1 dient beispielsweise dazu, eine Drehzahlmessung an einem Turbinenrotor 5 vorzunehmen.

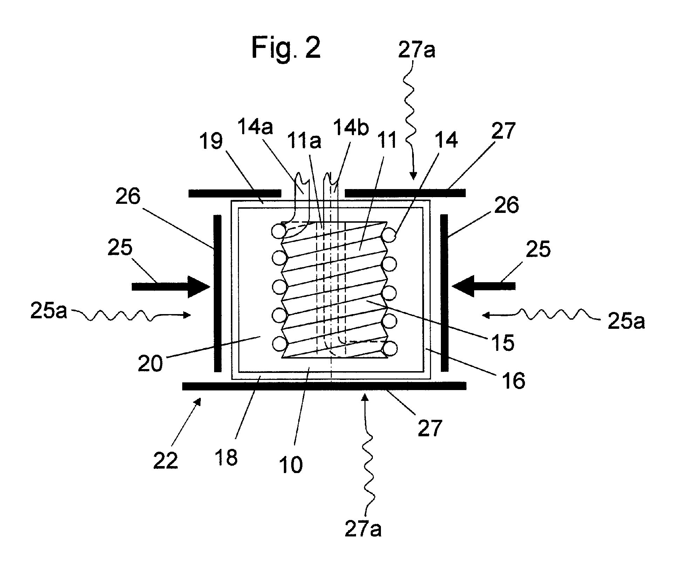

Die Figur 2 zeigt ein erstes Ausführungsbeispiel eines hochtemperaturfähigen induktiven Sensors 10. Der induktive Sensor 10 umfasst einen Wicklungskörper 11, der mit einer Induktionswicklung 14 umwickelt ist, wobei eine Spule 15 bereitgestellt ist. Die Induktionswicklung 14 weist zwei Wicklungsenden 14a, 14b auf, von denen das eine Wicklungsende 14b in einer mittigen, axialen Aussparung 11a des Wicklungskörpers 11 geführt ist, die sich am unteren Rand des Wicklungskörpers 11 zu dessen Außenfläche hin öffnet. Der Wicklungskörper 11 kann ein Außengewinde ausbilden, um das Wickeln der Induktionswicklung 14 zu erleichtern und die Wicklungen auf definiertem Abstand zueinander zu positionieren.

Die Spule 15 ist in einem Metallgehäuse 16 angeordnet und in dem Metallgehäuse 16 mit einem Metalloxid-Pulver 20, das der elektrischen Isolation dient, verpresst.

Das Metallgehäuse 16 ist temperaturbeständig bis zu einer gewünschten Mindesttemperatur, die beispielsweise bei 600 °C oder bei 800 °C liegt, ausgebildet. Es besteht beispielsweise aus einer Nickelbasislegierung, aus nicht rostendem Stahl, aus einer Titanlegierung oder aus einer anderen hochtemperaturfähigen Metalllegierung. Der Wicklungskörper 11 besteht beispielsweise aus einem keramischen oder einem dauermagnetischen Material. Die Induktionswicklung 14 besteht aus einer hochtemperaturfähigen Metalllegierung, beispielsweise einer Nickelbasislegierung oder einem nichtrostendem Stahl. Bei dem verpressten Metalloxid-Pulver 20 handelt es sich beispielsweise um ein Magnesiumoxid-, Zirkonoxid- oder Titanoxid-Pulver.

Der induktive Sensor der Figur 2 weist des Weiteren einen Boden 18 und einen Deckel 19 auf. Im dargestellten Ausführungsbeispiel, jedoch nicht notwendigerweise, bilden der Boden 18 und der Deckel 19 einen Teil des Gehäuses, und können somit ebenfalls aus Metall bestehen. Alternativ können Boden 18 und Deckel 19 aus Keramik bestehen. Die Wicklungsenden 14a, 14b der Induktionswicklung 14 ragen durch nicht näher dargestellte Öffnungen aus dem Deckel 19 nach oben heraus.

Durch die Form des Wicklungskörpers 11 und die Wicklung der Induktionsspule 15 sind eine axiale Richtung und eine radiale Richtung definiert.

Zum Verpressen des Metalloxid-Pulvers 20 im Metallgehäuse 16 werden in radialer Richtung von außen Presskräfte 25 auf das Metallgehäuse 16 aufgebracht. Dies erfolgt beispielsweise über bewegliche Backen 26 einer Pressvorrichtung 22, die beweglich sind und in radialer Richtung zur Bereitstellung der Presskräfte 25 gegen das Metallgehäuse 16 drücken und dieses dadurch verformen. Dabei kann vorgesehen sein, dass die radiale Pressung mehrfach unter versetzten Winkeln erfolgt, um eine erhöhte Rundheit des Metallgehäuses 16 zu erreichen. Die beweglichen Backen 26 sind idealerweise halbrund ausgeführt, um der Kontur des Metallgehäuses zu folgen.

Die axiale Erstreckung der beweglichen Backen 26 ist derart, dass ein Verformen des Metallgehäuses 16 im Bereich des Bodens 18 und im Bereich des Deckels 19 nicht erfolgt. Hierdurch wird insbesondere eine sonst mögliche Beschädigung der Anschlüsse bzw. Wicklungsenden 14a, 14b sicher vermieden, als auch ein definierter Abstand zwischen Wicklungskörper 11 und Boden 18 gewährleistet. In axialer Richtung ist das Metallgehäuse 16 in einem starren Teil der Pressvorrichtung 22 angeordnet, der beispielsweise durch fest eingespannte Platten 27 gebildet ist.

Auf die Bauteile der Pressvorrichtung 22, wie Backen 26, und/oder Platten 27 können zur Unterstützung des Pressvorganges hochfrequente Schwingungen 25a, 27a aufgebracht werden, um eine gleichmäßigere und höhere Verdichtung des Metalloxid-Pulvers 20 zu erreichen.

Nach dem Pressvorgang ist die hohlzylindrische Wandung des Metallgehäuses 16 in ihrem Durchmesser reduziert, so dass das Metallgehäuse 16 einer verpressten Presshülse ähnelt (mit unverformtem Boden 18 und Deckel 19). Durch das Verformen ist das Metalloxid-Pulver 20 im Metallgehäuse 16 verpresst, d. h. das Metalloxid-Pulver 20 liegt im Metallgehäuse 16 mit einem gegenüber dem Umgebungsdruck erhöhten Druck vor. Der Innendruck des Metalloxid-Pulvers kann üblichweise 10 bis 50 bar betragen, kann aber auch einen anderen Wert aufweisen.

Die Art und Weise des Pressvorgangs, der zu einem Verformen des Metallgehäuses 16 führt, kann grundsätzlich auf vielfältige Weise erfolgen. Ein radialer Pressvorgang mit zwei beweglichen Platten 26, wie in der Figur 2 dargestellt ist, ist lediglich beispielhaft zu verstehen. Beispielsweise kann der Pressvorgang auch durch ein oder mehrere Rollen erfolgen, die an der Außenseite des zylinderförmigen Metallgehäuses 16 anliegen und eine Presskraft ausüben. Auch kann der Pressvorgang axiale Komponenten umfassen, solange gewährleistet ist, dass die Wicklungsenden 14a, 14b nicht beschädigt werden, die Wicklungen 14 auf dem Wicklungskörper 11 nicht verschoben und ein definierter Abstand vom Wicklungskörper 11 zum Boden 18 erzielt wird.

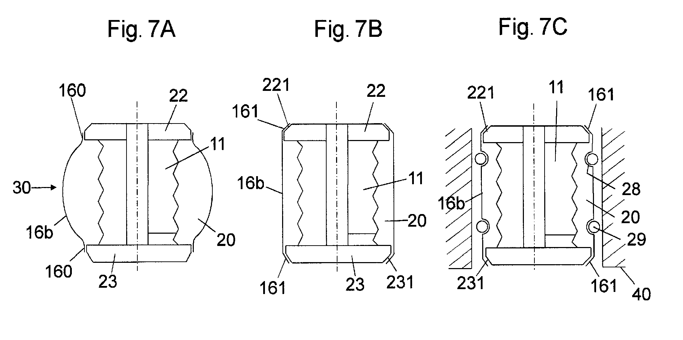

Weiter wird darauf hingewiesen, dass, wie in Bezug auf die Ausführungsbeispiele der Figuren 7A - 7C noch erläutert werden wird, der Boden 18 und der Deckel 19 nicht integraler Teil des Metallgehäuses 16 sein müssen, sondern alternativ auch als gesonderte Teile oder als integrierte Bestandteile des Wicklungskörpers 11 ausgeführt sein können.

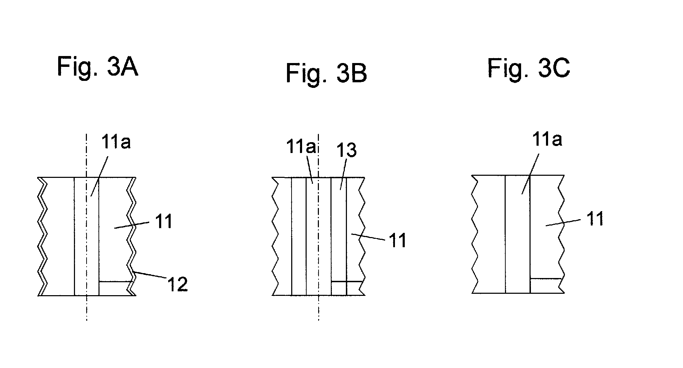

Die Figur 3A zeigt ein alternatives Ausführungsbeispiel des Wicklungskörpers 11 der Figur 2. Bei diesem Ausführungsbeispiel besteht der Wicklungskörper 11 aus einem dauermagnetischen Material. Zur Isolation gegen die nicht dargestellten Wicklungen 14 der Induktionsspule 15 ist der dauermagnetische Wicklungskörper 11 mit einer keramischen Beschichtung 12 versehen.

Die Figur 3B zeigt ein weiteres Ausführungsbeispiel eines Wicklungskörpers 11. Bei diesem Ausführungsbeispiel ist der keramische Wicklungskörper 11 hohl unter Ausbildung einer hohlzylindrischen Aufnahme 13 ausgebildet. Diese ist dafür vorgesehen und ausgebildet, einen Dauermagneten (nicht dargestellt) aufzunehmen, um die Induktivität des Sensors zu erhöhen. Ein solcher Dauermagnet ist hochtemperaturfähig und kann beispielsweise kobalt- oder eisen-basiert sein.

Die Figur 3C zeigt einen keramischen Wicklungskörper ohne Dauermagneten.

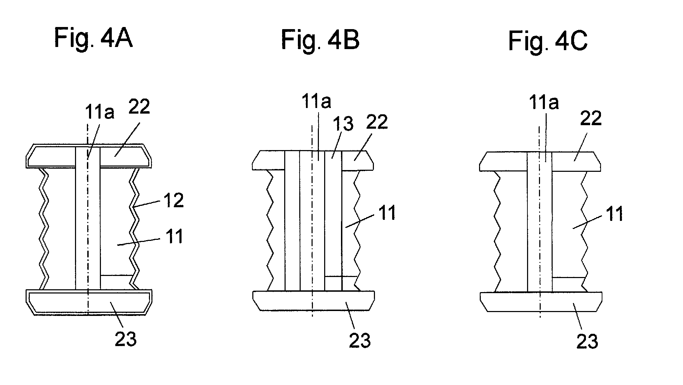

Die Figur 4A zeigt ein weiteres Ausführungsbeispiel eines Wicklungskörpers 11. In den Wicklungskörper 11 sind ein Deckel 22 und ein Boden 23 des induktiven Sensors integriert und einstückig mit diesem ausgebildet. Im Ausführungsbeispiel der Figur 4A besteht der Wicklungskörper 11 aus einem dauermagnetischen Material, weswegen der Wicklungskörper 11 des Weiteren eine keramische Beschichtung 12 aufweist.

Der Wicklungskörper 11 der Figur 4B besteht aus einem keramischen Material. Dabei sind ebenfalls ein Deckel 22 und ein Boden 23 in den Wicklungskörper 11 integriert. Der Wicklungskörper 11 weist eine Aussparung 13 zur Aufnahme eines Dauermagneten auf.

Die Figur 4C zeigt ein Ausführungsbeispiel eines keramischen Wicklungskörpers 11 mit integriertem Deckel 22 und Boden 23, der keine Aufnahme für einen Dauermagneten aufweist.

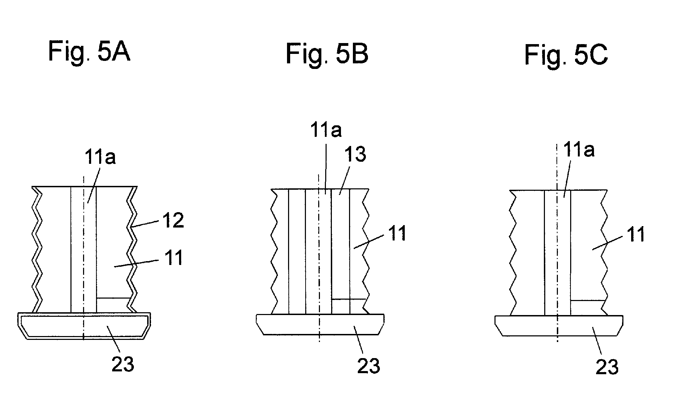

Die Figuren 5A bis 5C zeigen Wicklungskörper 11 entsprechend den Figuren 4A bis 4C, wobei der Wicklungskörper 11 jedoch nur einen integrierten Boden 23 (oder alternativ einen integrierten Deckel 22) aufweist.

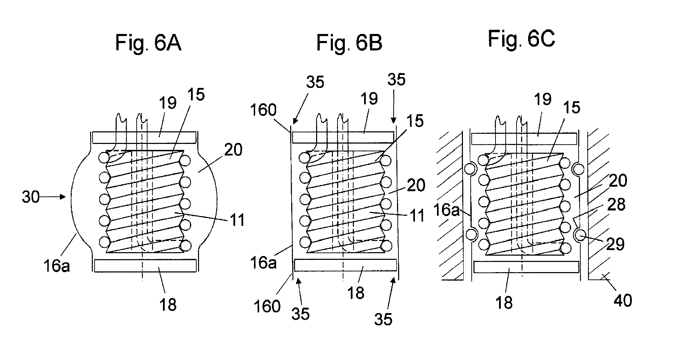

Die Figuren 6A und 6B zeigen ein Ausführungsbeispiel eines induktiven Sensors, wobei die Figur 6A den Zustand vor einem Verformen eines Metallgehäuses und die Figur 6B den Zustand nach dem Verformen des Metallgehäuses darstellt. Gemäß der Figur 6A ist eine auf einen Wicklungskörper 11 gewickelte Induktionsspule 15, die beispielsweise entsprechend der Ausgestaltung der Figur 2 ausgebildet ist, zusammen mit Metalloxid-Pulver 20 in einem Metallgehäuse angeordnet, das durch einen metallenen Boden 18, einen metallenen Deckel 19 sowie ein Metallrohr 16a gebildet ist. Dabei weist das Metallrohr 16a eine bauchförmige Ausdellung 30. Das Metallrohr 16a liegt an seinen Enden verschiebbar an Boden 18 und Deckel 19 an, so dass ein im Wesentlichen geschlossenes Metallgehäuse mit darin angeordnetem Metalloxid-Pulver 20 vorliegt.

Anschließend erfolgt ein radiales Pressen des Metallrohrs 16a, beispielsweise über Pressbacken 26 entsprechend den beweglichen Backen 26 der Figur 2 oder über Rollen. Dabei kann vorgesehen sein, dass Pressbacken und dergleichen mehrfach unter versetzten Winkeln angesetzt werden, um eine Rundheit des Metallrohrs 16a zu erhalten. Durch das Aufbringen von Presskräften axial außen an das Metallrohr 16a wird die Ausdellung 30 beseitigt. Dies geht einher mit einem Verpressen des Metalloxid-Pulvers 20 im Metallgehäuse 16a, 18, 19.

Das Beseitigen der Ausdellung 30 des Metallrohrs 16a durch das Aufbringen von Presskräften gegen das Metallrohr 16a geht einher mit einer Verlängerung des Metallrohrs 16a, so dass dessen stirnseitigen Enden 160 nun weiter gegenüber dem Boden 18 und dem Deckel 19 vorstehen. Es erfolgt nun über Schweiß- oder Lötnähte 35 eine feste Verbindung zwischen dem Metallrohr 16a und dem Boden 18 und dem Deckel 19.

Alternativ zu den Schweiß- oder Lötnähten können Boden 18 und/oder Deckel 19 in das Metallrohr 16a eingebördelt werden, insbesondere wenn Boden 18 und Deckel 19 aus Keramik bestehen.

Die Figur 6B zeigt den induktiven Sensor nach Beendigung des Pressvorgangs. Das Metallrohr 16a ist nun im Wesentlichen zylinderförmig ausgebildet.

Die Figur 6C zeigt eine Abwandlung des induktiven Sensors der Figur 6B, bei der in der Außenseite des Metallgehäuses 16a ein oder mehrere umfängliche Nuten 28 ausgebildet sind, in denen jeweils ein Dichtmittel, beispielsweise eine Dichtschnur 29 angeordnet ist. Hierdurch wird eine Dichtung des induktiven Sensors gegenüber außen liegenden Komponenten ermöglicht, die beispielsweise einen Sensorsitz 40 bilden.

Die Figuren 7A und 7B zeigen ein weiteres Ausführungsbeispiel eines induktiven Sensors vor und nach dem Verformvorgang des Metallgehäuses, wobei die Induktionsspule nicht dargestellt ist. Beim Ausführungsbeispiel der Figuren 7A und 7B sind der Deckel 22 und der Boden 23 entsprechend den Ausgestaltungen der Figuren 4A bis 4C in den Wicklungskörper 11 integriert. In diesem Ausführungsbeispiel besteht somit nur ein Metallrohr 16b aus Metall, während der Boden 23 und der Deckel 22 des Sensors durch den keramischen Wicklungskörper 11 bereitgestellt sind.

Auch bei der Ausgestaltung der Figur 7A weist das Metallrohr 16b im Anfangszustand eine bauchige Ausdellung 30 auf. Die Enden 160 des Metallrohrs 16b sind vor Durchführung des Verformvorgangs nicht fest mit dem Deckel 22 bzw. dem Boden 23 verbunden, so dass eine Relativbewegung noch möglich ist. Jedoch liegen sie unmittelbar an den seitlichen Kanten von Deckel 22 und Boden 23 an, so dass beim Pressvorgang im Wesentlichen kein Metalloxid-Pulver 20 entweichen kann.

Die Figur 7B zeigt den induktiven Sensor nach Durchführung des Pressvorgangs zur Verformung des Metallgehäuses 16b. Der Pressvorgang selbst wird wie in Bezug auf die Figuren 6A und 6B beschrieben durchgeführt. Aufgrund des Pressvorgangs hat sich die axiale Ausdehnung des Metallrohres 16b vergrößert. Dies wird dazu genutzt, eine Bördelung 161 an den Enden des Metallrohres 16b nach dem Ende des Verformvorgangs auszubilden, wobei die Bördelung an Fasen 221, 231 von Deckel 22 und Boden 23 anliegt, wodurch ein formschlüssiger Verschluss des Gehäuses, das in diesem Ausführungsbeispiel aus dem Metallgehäuse 16b und den in den keramischen Wicklungskörper integrierten Deckel 22 und Boden 23 besteht, bereitgestellt wird.

Auch beim Ausführungsbeispiel der Figur 7B kann ähnlich wie beim Ausführungsbeispiel der Figur 6C vorgesehen sein, dass an der Außenseite des Metallgehäuses 16b ein oder mehrere umfängliche Nuten 28 ausgebildet sind, in denen jeweils ein Dichtmittel, etwa in Form einer Dichtschnur 29, angeordnet sind, die eine Abdichtung gegenüber einer angrenzenden Struktur wie z.B. einem Sensorsitz 40 bereitstellen. Dies ist in der Figur 7C dargestellt.

In weiteren Ausgestaltungen der Erfindung sind Wicklungskörper 11 nur mit integrierten Boden 23 entsprechend den Figuren 5A - 5C oder nur mit integrierten Deckel 22 in ein Metallgehäuse eingebracht. Die Anordnung und das Verpressen erfolgen entsprechend den Figuren 7A - 7B, wobei jedoch entweder nur Boden 23 oder nur Deckel 22 in den keramischen Wicklungskörper 11 integriert sind. Das jeweils nicht integrierte Teil (Deckel oder Boden) wird entsprechend den Figuren 6A - 6B bereitgestellt.

Die Erfindung beschränkt sich in ihrer Ausgestaltung nicht auf die vorstehend dargestellten Ausführungsbeispiele, die lediglich beispielhaft zu verstehen sind. Beispielsweise können Form und Ausgestaltung des Wicklungskörpers und des Metallgehäuses von den dargestellten Ausführungsbeispielen abweichen. Auch kann ein Verformen des Metallgehäuses in anderer Weise als beschrieben erfolgen. Des weiteren wird darauf hingewiesen, dass die Merkmale der einzelnen beschriebenen Ausführungsbeispiele der Erfindung in verschiedenen Kombinationen miteinander kombiniert werden können. Sofern Bereiche definiert sind, so umfassen diese sämtliche Werte innerhalb dieser Bereiche sowie sämtliche Teilbereiche, die in einen Bereich fallen.

## Patentansprüche

1. Induktiver Sensor (10), der aufweist:
- einen Wicklungskörper (11),
- eine Induktionsspule (15) aus einer hochtemperaturfähigen Metalllegierung, die auf den Wicklungskörper (11) gewickelt ist, und
- ein die Induktionsspule (11) zumindest teilweise umgebendes Metallgehäuse (16, 16a, 16b),
- wobei die Induktionsspule (15) mit Metalloxid-Pulver (20) im Metallgehäuse (16, 16a, 16b) verpresst ist.

2. Sensor nach Anspruch 1, **dadurch gekennzeichnet, dass** der Wicklungskörper (11) als hochtemperaturfähiger Dauermagnet mit einer keramischen Beschichtung (12) ausgebildet ist.

3. Sensor nach Anspruch 1, **dadurch gekennzeichnet, dass** der Wicklungskörper (11) als keramischer Wicklungskörper ausgebildet ist.

4. Sensor nach einem der vorangehenden Ansprüche, **dadurch gekennzeichnet, dass** das Metallgehäuse (16, 16a, 16b) bis zu einer Temperatur von mindestens 600 °C, insbesondere bis zu einer Temperatur von mindestens 800 °C temperaturbeständig ausgebildet ist.

5. Sensor nach einem der vorangehenden Ansprüche, **dadurch gekennzeichnet, dass** das Metallgehäuse (16, 16a, 16b) aus einer Nickelbasislegierung, aus nicht rostendem Stahl, aus einer Titanlegierung oder aus einer anderen hochtemperaturfähigen Metalllegierung besteht.

6. Sensor nach einem der vorangehenden Ansprüche, **dadurch gekennzeichnet, dass** das Metallgehäuse (16a, 16b) rohrförmig oder balgförmig ausgebildet ist.

7. Sensor nach einem der vorangehenden Ansprüche, **dadurch gekennzeichnet, dass** der Wicklungskörper (11) einen Deckelbereich (22) und einen Bodenbereich (23) ausbildet, an denen das Metallgehäuse (16a, 16b) befestigt ist.

8. Sensor nach einem der vorangehenden Ansprüche, **dadurch gekennzeichnet, dass** in der Außenseite des Metallgehäuses (16a, 16b) mindestens eine umfängliche Nut (28) ausgebildet ist, in der ein Dichtmittel, beispielsweise eine hochtemperaturfähige Dichtschnur (29), angeordnet ist.

9. Sensor nach einem der vorangehenden Ansprüche, **dadurch gekennzeichnet, dass** die Induktionsspule (15) aus einer Nickelbasislegierung oder aus nicht rostendem Stahl besteht.

10. Verfahren zum Herstellen eines induktiven Sensors (10), mit den Schritten:
- Wickeln einer Induktionsspule (15) aus einer hochtemperaturfähigen Metalllegierung auf einen Wicklungskörper (11),
- Anordnen der auf den Wicklungskörper (11) gewickelten Induktionsspule (15) in einem Metallgehäuse (16, 16a, 16b) zusammen mit einem Metalloxid-Pulver (20),
- Verschließen des Metallgehäuses (16, 16a, 16b) derart, dass im Wesentlichen kein Metalloxid-Pulver (20) nach außen treten kann, und
- anschließend Verformen des Metallgehäuses (16, 16a, 16b), wobei die Induktionsspule mit dem Metalloxid-Pulver (20) verpresst wird, wobei das Metallpulver nach dem Verpressen weiterhin als Metallpulver vorliegt und nicht versintert ist.

11. Verfahren nach Anspruch 10, **dadurch gekennzeichnet, dass** das Metallgehäuse (16, 16a, 16b) zum Verformen mindestens einmal in radialer Richtung von außen gepresst wird.

12. Verfahren nach Anspruch 10 oder 11, **dadurch gekennzeichnet, dass** das Metallgehäuse (16a, 16b) vor dem Verformen eine Wölbung (30) nach außen aufweist und das Metallgehäuse (16a, 16b) verformt wird, indem auf die Wölbung (30) von außen Druck ausgeübt wird.

13. Verfahren nach Anspruch 12, **dadurch gekennzeichnet, dass** das Metallgehäuse (16a, 16b) als Metallbalg ausgebildet ist, wobei der Metallbalg vor dem Verformen eine Ausdellung (30) besitzt, die durch das Verformen im Wesentlichen beseitigt wird.

14. Verfahren nach einem der Ansprüche 10 bis 13, **dadurch gekennzeichnet, dass** zur Unterstützung des Verpressens des Metalloxid-Pulvers (20) hochfrequente Schwingungen (25a, 27a) in das Metalloxid-Pulver (20) eingebracht werden.

15. Verfahren nach einem der Ansprüche 10 bis 14, **dadurch gekennzeichnet, dass** zumindest das Verpressen der Induktionsspule (15) mit dem Metalloxid-Pulver (20) unter Vakuum stattfindet.
